# EUROPÄISCHE PATENTANMELDUNG

(11) **EP 1 814 223 A1**
(43) Veröffentlichungstag der Anmeldung: **01.08.2007**
(21) Anmeldenummer: 07001225.7
(22) Anmeldetag: 20.01.2007
(51) Int. Cl.: H03H 7/38, H01P 5/02

(54) **Vorrichtung zum Übertragen elektromagnetischer Signale und deren Verwendung**

(30) Priorität: 25.01.2006 DE 102006003474
(71) Anmelder: ATMEL Germany GmbH, 74072 Heilbronn (DE)
(72) Erfinder: Zimmerling, Detlef, 74246 Eberstadt (DE)

(57) **Zusammenfassung**

Eine Vorrichtung (1) zum Übertragen von elektromagnetischen Signalen zwischen wenigstens einer ersten und wenigstens einer zweiten Funktionseinheit (11.1, 11.2), insbesondere im HF-Bereich, umfasst ein elektrisch isolierendes Substrat mit einer Oberseite und einer Unterseite, eine erste elektrisch leitfähige Schicht aus einem ersten Beschichtungsmaterial auf der Unterseite des Substrats, die mit einem Bezugspotential verbindbar ist, und eine zweite elektrisch leitfähige Schicht (3) aus einem zweiten Beschichtungsmaterial auf der Oberseite des Substrats, wobei die zweite elektrisch leitfähige Schicht (3) in wenigstens einem Bereich (3.1, 3.2) in Form voneinander räumlich getrennter und gegeneinander elektrisch isolierter Felder (3.1a, 3.1b, ...; 3.2a, 3.2b, ...) aus dem zweiten Beschichtungsmaterial ausgebildet ist. Bei einer derartigen Vorrichtung (1) wird vorgeschlagen, dass die Felder (3.1a, 3.1b, ...; 3.2a, 3.2b, ...) bereichsweise gegenüber der ersten elektrisch leitfähigen Schicht jeweils eine gleiche, vorbestimmte Kapazität aufweisen und dass durch Vorsehen elektrisch leitender Verbindungen (12.1-12.4) zwischen einer Anzahl von diesen Feldern (3.1a, 3.1b, ...; 3.2a, 3.2b, ...) an einer Oberseite der zweiten leitfähigen Schicht (3) ein Transformationsverhalten der Vorrichtung (1) zur Impedanzanpassung gezielt einstellbar ist.

## Beschreibung

Die vorliegende Erfindung betrifft eine Vorrichtung zum Übertragen von elektromagnetischen Signalen zwischen wenigstens einer ersten und wenigstens einer zweiten Funktionseinheit, insbesondere im Hochfrequenz (HF)-Bereich, aufweisend: ein elektrisch isolierendes Substrat mit einer Oberseite und einer Unterseite, eine erste elektrisch leitfähige Schicht aus einem ersten Beschichtungsmaterial auf der Unterseite des Substrats, die mit einem Bezugspotential verbindbar ist, und eine zweite elektrisch leitfähige Schicht aus einem zweiten Beschichtungsmaterial auf der Oberseite des Substrats, wobei die zweite leitfähige Schicht in wenigstens einem Bereich in Form jeweils voneinander räumlich getrennter und gegeneinander elektrisch isolierter Felder aus dem zweiten Beschichtungsmaterial ausgebildet ist.

Weiterhin betrifft die vorliegende Erfindung ein Verfahren zum Herstellen eines Impedanz-Transformationsnetzwerks, ein Verfahren zum Entwickeln von Schaltungsanordnungen (Prototypenentwicklung) sowie mögliche Verwendungen der erfindungsgemäßen Vorrichtung.

Zum Anpassen von eingangs- bzw. Ausgangs-Impedanzen miteinander in signaltechnischer Wirkverbindung stehender elektrischer Funktionseinheiten wird in der Praxis regelmäßig zwischen den Funktionseinheiten ein sogenanntes Transformations- oder Anpassungs-Netzwerk angeordnet. Dieses stellt eine Transformationsleitung dar und umfasst in der Regel eine Reihe von diskreten elektrischen Bauelementen, wie Kondensatoren, Spulen oder dergleichen, um auf diese Weise die Impedanzen der zusammengeschalteten Baugruppen / Funktionseinheiten zu transformieren, d.h. aneinander anzupassen. Im Zuge einer Vermessung von Baugruppen / Funktionseinheiten müssen dabei auch die Messkontakte der verwendeten Messfassungen mit kompensiert werden.

Aus der WO 94/02310 A1 ist eine Vorrichtung der genannten Art in Form einer gedruckten Schaltungsplatine bekannt, die wenigstens einen internen Kondensator mit oberen und unteren leitfähigen Schichten und einem dazwischen liegenden isolierenden Material aufweist. Der Kondensator ist in Innern der Platine angeordnet und dient zur Unterdrückung von Spannungsfluktuationen als Bypass-Kondensator für auf der Platine vorhandene elektronische Einheiten. Eine vergleichbare Vorrichtung offenbart auch die US 5,870,274 A.

Die US 5,817,533 A beschreibt ein Verfahren zum Herstellen von Kondensatoren, bei dem eine obere Elektrode des Kondensators in Form separater quadratischer Felder ausgebildet ist, sodass eine Anzahl von Teil-Kondensatoren entstehen. Diese werden einzeln getestet, und nur fehlerfreie Teil-Kondensatoren werden anschließend zu einem Gesamt-Kondensator elektrisch leitend verbunden.

Bei hohen Frequenzen der verwendeten elektromagnetischen Signale, beispielsweise in einem Bereich von 2 GHz und höher, d.h. im Bereich von Mikrowellen, können zur Impedanzanpassung diskrete Bauelemente nur bedingt verwendet werden, da diese bei den genannten hohen Frequenzen kein reales Verhalten mehr aufweisen. Der Ausdruck "kein reales Verhalten" bedeutet in diesem Zusammenhang, dass beispielsweise eine Kapazität nicht nur rein kapazitive sondern zugleich auch induktive sowie resistive Eigenschaften aufweist, sodass in einem entsprechenden Ersatzschaltbild zur Darstellung eines derartigen Bauteile viele zusammenwirkende Einzelkomponenten erforderlich wären.

Die vorliegende Anmeldung bzw. Erfindung beschäftigt sich dementsprechend und in Abgrenzung zu dem oben gewürdigten Stand der Technik mit dem Problem der Impedanzanpassung bei der Übertragung elektromagnetischer Signale. Ihr liegt diesbezüglich die Aufgabe zu Grunde, eine Vorrichtung der eingangs genannten Art zu schaffen, mit der in einfacher und reproduzierbarer Weise auch bei den genannten hohen Signalfrequenzen, vorzugsweise mindestens bis 4 GHz, eine Impedanzanpassung signaltechnisch wechselwirkender Funktionseinheiten erreicht werden kann.

Des Weiteren sollen ein Verfahren zum Erreichen einer entsprechenden Impedanzanpassung und ein Verfahren zum Entwickeln von Schaltungsanordnungen (Prototypen)bei den genannten hohen Signalfrequenzen, vorzugsweise mindestens bis 4 Ghz, angegeben werden.

Die Aufgabe wird gemäß einem ersten Aspekt der vorliegenden Erfindung bei einer Vorrichtung der eingangs genannten Art dadurch gelöst, dass die Felder bereichsweise gegenüber der ersten elektrisch leitfähigen Schicht jeweils eine gleiche, vorbestimmte Kapazität aufweisen und dass durch Vorsehen elektrisch leitender Verbindungen zwischen einer Anzahl von diesen Feldern an einer Oberseite der zweiten leitfähigen Schicht ein Transformationsverhalten der Vorrichtung zur Impedanzanpassung gezielt einstellbar ist.

Die Felder besitzen jeweils die über der auf der Unterseite des Substrats angeordneten ersten elektrisch leitfähigen Schicht eine bestimmte, insbesondere von den Feldabmessungen, der Substratdicke sowie der relativen Permeabilität des Substratmaterials abhängige Kapazität. Auf diese Weise lassen sich durch leitfähiges Verbinden der genannten Felder zu durchgängigen Leitungen und hiervon abgehenden Stich- oder Blindleitungen Verbindungen zwischen den Funktionseinheiten geschaffen, denen je nach Anzahl und Position der zu Stich- oder Blindleitungen verbundenen Felder jeweils eine bestimmte Kapazität parallel geschaltet ist, was für den Fachmann ein geeignetes Mittel zur Impedanzanpassung darstellt. Demnach fungieren die jeweils räumlich voneinander getrennten und gegeneinander elektrisch isolierten Felder der erfindungsgemäßen Vorrichtung als eine Art "Einheitskapazität", die sich in der vorstehend skizzierten Art hochflexibel in ein zu schaffendes Anpassungs-Netzwerk einschalten lässt, für welches die erfindungsgemäße Vorrichtung als eine besondere Art von Halbzeug fungiert.

Gemäß einem zweiten Aspekt der vorliegenden Erfindung schafft diese ein Verfahren zum Herstellen eines Impedanz-Transformationsnetzwerks unter Verwendung einer erfindungsgemäßen Vorrichtung, wobei eine erste Funktionseinheit mit einer ersten Anschlussimpedanz elektrisch leitend in einem ersten Bereich mit der zweiten elektrisch leitfähigen Schicht verbunden wird; eine zweite Funktionseinheit mit einer zweiten Anschlussimpedanz elektrisch leitend in einem zweiten Bereich mit der zweiten leitfähigen Schicht verbunden wird; falls der erste und zweite Bereich nicht durch eine leitfähige Verbindung aus dem zweiten Beschichtungsmaterial miteinander verbunden sind, an der Oberseite der zweiten elektrisch leitfähigen Schicht eine elektrisch leitfähige Verbindung zwischen dem ersten und dem zweiten Bereich hergestellt wird; und ausgehend von der leitfähigen Verbindung eine Anzahl von an ihrem jeweiligen Ende offenen Stichleitungen durch Verbinden jeweils einer Anzahl von Feldern mit einem elektrisch leitfähigen Material sowohl untereinander als auch mit der leitfähigen Verbindung an der Oberseite der zweiten elektrisch leitfähigen Schicht erzeugt wird, wobei eine jeweilige Position und Anzahl von Feldern derart gewählt wird, dass eine Differenz zwischen den ersten und zweiten Anschlussimpedanzen ausgeglichen wird.

Gemäß einem dritten Aspekt der vorliegenden Erfindung schafft diese ein Verfahren zum Entwickeln von Schaltungsanordnungen (Prototypentwicklung) unter Verwendung einer erfindungsgemäßen Vorrichtung, wobei eine Mehrzahl von Funktionseinheiten jeweils in Bereichen der zweiten elektrisch leitfähigen Schicht elektrisch leitend mit dieser verbunden werden und wobei wenigstens eine Anzahl von Feldern mit einem elektrisch leitfähigen Material an der Oberseite der zweiten elektrisch leitfähigen Schicht miteinander verbunden werden, sodass die verbundenen Felder mit den Funktionseinheiten in signaltechnischer Wirkverbindung stehen.

Vorteilhafte Weiterbildungen der Vorrichtung und der Verfahren sind jeweils Gegenstand von Unteransprüchen, deren Wortlaut hiermit durch Bezugnahme in die Beschreibung aufgenommen werden, um Textwiederholungen zu vermeiden.

Das angesprochene Verbinden der Felder untereinander kann dabei erfindungsgemäß in einfacher Weise oberflächlich, d.h. an der Oberseite der zweiten elektrisch leitfähigen Schicht durch das Aufbringen geeignet positionierter Zinnbrücken aus Lötzinn oder durch Auflegen eines in geeigneter Weise beweglichen und verstellbaren Kurzschluss-Leiters erfolgen. Zu diesem Zweck ist in Weiterbildung der erfindungsgemäßen Vorrichtung vorgesehen, dass die Felder untereinander an der Oberseite der zweiten elektrisch leitfähigen Schicht elektrisch leitend miteinander verbindbar sind.

Die zweite leitfähige Schicht besteht erfindungsgemäß vorzugsweise aus Kupfer, wobei die vorstehend beschreibene Strukturierung beispielsweise durch Standard-Ätztechniken erzeugt wird.

Um insbesondere für den Benutzer eine leicht planbare und überschaubare Anpassbarkeit der erfindungsgemäßen Vorrichtung zu erreichen, ist in einer bevorzugten Weiterbildung der erfindungsgemäßen Vorrichtung vorgesehen, dass die Felder bereichsweise gleiche Abmessungen aufweisen und/oder gitterförmig angeordnet sind. Dabei weist das Gitter vorzugsweise eine regelmäßige Gitterstruktur auf, die im Zuge einer weiteren Ausgestaltung der erfindungsgemäßen Vorrichtung in Form eines quadratischen Gitters ausgestaltet ist, sodass alle Felder aufgrund ihrer identischen Abmessungen prinzipiell eine identische Kapazität darstellen.

Um darüber hinaus in einfacher Art und Weise zunächst eine direkte Verbindung der beiden impedanzmäßig anzupassenden Funktionseinheiten zu ermöglichen, sieht eine äußerst bevorzugte Ausgestaltung der erfindungsgemäßen Vorrichtung vor, dass diese wenigstens einen durchgängigen und gegenüber den Feld-Bereichen der zweiten elektrisch leitfähigen Schicht elektrisch isolierten Streifen aus einem elektrisch leitfähigen Beschichtungsmaterial aufweist. Bei dem elektrisch leitfähigen Beschichtungsmaterial dieses Streifens handelt es sich vorzugsweise um das zweite Beschichtungsmaterial, sodass die zweite elektrisch leitfähige Schicht und der durchgängige Streifen aus demselben Beschichtungsmaterial bestehen, was fertigungstechnisch eine bedeutende Vereinfachung bedeutet.

In Weiterbildung der erfindungsgemäßen Vorrichtung ist vorgesehen, dass diese mindestens zwei Bereiche mit Feldern des zweiten Beschichtungsmaterials aufweist, die durch den durchgängigen Streifen voneinander getrennt sind.

Um eine möglichst einfache Handhabbarkeit der erfindungsgemäßen Vorrichtung und darüber hinaus auch deren Einbau und dauerhafte Verwendung in elektronischen Geräten zu ermöglichen, sieht eine Weiterbildung der erfindungsgemäßen Vorrichtung vor, dass das Substrat in Form einer Substratplatte, d.h. plattenförmig bzw. flach ausgebildet ist. Als Plattenmaterial kann beispielsweise FR4 oder jedes andere für HF-Anwendungen geeignete Material verwendet werden.

Zum Erreichen einer erhöhten Flexibilität der Einsetzbarkeit der erfindungsgemäßen Vorrichtung, beispielsweise bei der Schaltungsentwicklung, kann in Weiterbildung darüber hinaus vorgesehen sein, dass mit dem zweiten Beschichtungsmaterial elektrische Funktionseinheiten, insbesondere diskrete elektrische Bauelemente, elektrisch leitend verbindbar sind, insbesondere durch Lötverbindungen. Mit anderen Worten: die Felder der erfindungsgemäßen Vorrichtung dienen erfindungsgemäß analog zu herkömmlichen Leiterplatten als Lösungsstützpunkte für den Aufbau und die Entwicklung komplexer elektronischer Schaltungsanordnungen.

Nach einer Ausgestaltung der erfindungsgemäßen Vorrichtung ist die erste elektrisch leitfähige Schicht mit einem Bezugspotential, z.B. Masse, verbindbar, wobei die Felder der zweiten Schicht - wie bereits erwähnt - gegenüber der ersten Schicht jeweils eine vorbestimmte Kapazität besitzen. Vorzugsweise beträgt diese vorbestimmte Kapazität nach einem Ausführungsbeispiel der vorliegenden Erfindung etwa 0,3 pF. Allerdings ist jeder andere Kapazitätswert zur Lösung der o.g. Aufgabe grundsätzlich ebenso geeignet.

Um eine möglichst große Anpassungsfähigkeit der erfindungsgemäßen Vorrichtung zu gewährleisten, ist nach einer äußerst bevorzugten Weiterbildung vorgesehen, dass der durchgängige Streifen als Leitung mit einem vorbestimmten Ohmschen Widerstand, für Standardanwendungen vorzugsweise als 50 Ohm-Leitung, ausgebildet ist. Wenn zudem auch die Abmessungen der einzelnen Felder in Übereinstimmung mit einer entsprechenden Abmessung (Breite) des durchgängigen Streifens gewählt werden, so ergibt sich im Zuge einer äußerst bevorzugten Weiterbildung der erfindungsgemäßen Vorrichtung, dass zumindest eine bereichsweise zusammengehörige Anzahl von Feldern der zweiten elektrisch leitfähigen Schicht denselben Ohmschen Widerstand aufweist, wie der durchgängige Streifen, sodass sich durch geeignetes Verbinden von Feldern wiederum eine Leitung mit denselben vorbestimmten Ohmschen Widerstand, vorzugsweise also wiederum eine 50 Ohm-Leitung erzeugen lässt.

Die vorstehend genannten Zahlenwerte lassen sich beispielsweise im Falle einer Verwendung von FR4 als Substratmaterial dadurch erreichen, dass für die Substratdicke ein Wert d = 1,5 mm und für die quadratischen Felder eine Kantenlänge k = 2,54 mm gewählt wird. Alternativ ist z.B. auch das Wertepaar d = 0,5 mm / k = 0,83 mm realisierbar. Die zwischen den Feldern der zweiten elektrisch leitfähigen Schicht sowie zwischen den Feldern und dem durchgängigen Streifen angeordneten Trennstrukturen besitzen nach einem Ausführungsbeispiel der vorliegenden Erfindung eine Breite von 1/10 k.

Vorteilhafterweise kann im Rahmen einer Weiterbildung der erfindungsgemäßen Vorrichtung auch vorgesehen sein, dass zumindest das zweite Beschichtungsmaterial zum Schaffen zusätzlicher elektrischer Trennstrukturen bereichsweise von dem Substrat entfernbar ist, insbesondere mit mechanischen Mitteln. Eine derartige Ausgestaltung der erfindungsgemäßen Vorrichtung erhöht weiterhin deren Einsatzflexibilität bei der Erzeugung komplexer Prototypen bzw. Schaltungsanordnungen.

Wie vorstehend bereits angeklungen ist, lässt sich die erfindungsgemäße Vorrichtung in vorteilhafter Weise, insbesondere zum Herstellen eines Impedanz-Transformationsnetzwerks, insbesondere für HF-Anwendungen, einsetzen. Zu diesem Zweck wird erfindungsgemäß eine erste Funktionseinheit mit einer ersten Anschlussimpedanz elektrisch leitend in einem ersten Bereich mit der zweiten elektrisch leitfähigen Schicht verbunden. Weiterhin wird eine zweite Funktionseinheit mit einer zweiten Anschlussimpedanz elektrisch leitend in einem zweiten Bereich mit der zweiten elektrisch leitfähigen Schicht verbunden. Um überhaupt eine Signalübertragung zwischen den ersten und zweiten Funktionseinheiten zu ermöglichen, wird an der Oberseite der zweiten elektrisch leitfähigen Schicht eine elektrisch leitfähige Verbindung zwischen dem ersten und dem zweiten Bereich hergestellt, falls der erste und der zweite Bereich nicht bereits an sich durch eine leitfähige Verbindung aus dem zweiten Beschichtungsmaterial miteinander verbunden sind. Insbesondere kann es sich bei dieser (bestehenden) elektrisch leitfähigen Verbindung zwischen dem ersten und dem zweiten Bereich um den bereits erwähnten durchgängigen Streifen gemäß einer Ausgestaltung der erfindungsgemäßen Vorrichtung handeln, an den entsprechend sowohl die erste als auch die zweite Funktionseinheit angeschlossen sind. Anschließend werden ausgehend von der geschaffenen oder bestehenden leitfähigen Verbindung eine Anzahl an ihrem jeweiligen Ende offener Stich- / Blindleitungen durch Verbinden jeweils einer Anzahl von Feldern mit einem elektrisch leitfähigen Material sowohl untereinander als auch mit der leitfähigen Verbindung an der Oberseite der zweiten elektrisch leitfähigen Schicht erzeugt. Derartige Stich- / Blindleitungen stellen jeweils eine Kapazität dar, die erfindungsgemäß der Verbindung zwischen den beiden Funktionseinheiten parallel geschaltet ist. Um auf diese Weise erfindungsgemäß die gewünschte Impedanzanpassung zu erreichen, wird eine jeweilige Position und/oder Anzahl von zu verbindenden Feldern derart gewählt, dass eine Differenz zwischen den ersten und zweiten Anschlussimpedanzen ausgeglichen wird. Dies entspricht physikalisch dem Parallelschalten einer Kapazität unter Verwendung diskreter Bauteile.

Des Weiteren lässt sich die erfindungsgemäße Vorrichtung auch allgemein zur Entwicklung von Schaltungsanordnungen bzw. zu Prototypentwicklung, insbesondere für HF-Anwendungen, einsetzen. Zu diesem Zweck wird eine Mehrzahl von Funktionseinheiten jeweils in Bereichen der zweiten elektrisch leitfähigen Schicht elektrisch leitend mit dieser verbunden. Daneben wird weiterhin wenigstens eine Anzahl von Feldern mit einem elektrisch leitfähigen Material an der Oberseite der zweiten elektrisch leitfähigen Schicht miteinander verbunden, sodass die verbundenen Feldern mit den Funktionseinheiten in signaltechnischer Wirkverbindung stehen. Des Weiteren können zum Schaffen komplexer Prototypen/Schaltungsanordnungen, wie Bandfilter, Hochpässe, Tiefpässe, Schwingkreise, Saugkreise, Verstärker usw., im Zuge einer äußerst bevorzugten Verwendung der erfindungsgemäßen Vorrichtung auch diskrete elektronische Bauelemente, wie Widerstände, Kondensatoren, LEDs, Schalter usw., mit Feldern der zweiten elektrisch leitfähigen Schicht elektrisch leitend verbunden werden, sodass die verbundenen Felder mit den Funktionseinheiten in signaltechnischer Wirkverbindung stehen. Hierbei kann vorgesehen sein, dass das Verbinden einzelner Felder jeweils mittels eines geeigneten diskreten Bauelements erfolgt.

Auf diese Weise ist im Rahmen der vorliegenden Erfindung eine Vorrichtung zum Übertragen elektromagnetischer Signale, insbesondere in Form einer Transformationsleitung, geschaffen, die grundsätzlich ohne diskrete Bauteile auskommt, somit grundsätzlich keinen negativen Toleranzeinflüssen unterliegt. Sie zeichnet sich darüber hinaus durch Langzeitkonstanz und ein hohes Maß an Reproduzierbarkeit aus. Insbesondere bei der Impedanzanpassung ist auf diese Weise ein leichter Abgleich von Impedanzdifferenzen möglich. Die erfindungsgemäße Vorrichtung wurde für einen Einsatz bis hin zu Signalfrequenzen von 4 GHz erprobt, und ist somit auch im Mikrowellenbereich problemlos einsetzbar, jedoch keinesfalls auf diesen Bereich beschränkt. Aufgrund ihrer spezifischen Ausgestaltung ist sie leicht in ein Layout zu integrieren und ermöglicht darüber hinaus das Ausgleichen quasi beliebiger Messfassungs- / Leitungs-Längen.

Weitere Eigenschaften und Vorteile der vorliegenden Erfindung ergeben sich aus der nachfolgenden Beschreibung von Ausführungsbeispielen anhand der Zeichnung. Es zeigt:
- Fig. 1: eine schematische Draufsicht auf eine erfindungsgemäße Vorrichtung zum Übertragen von elektromagnetischen Signalen;
- Fig. 2: einen Schnitt durch die erfindungsgemäße Vorrichtung aus Fig. 1;
- Fig. 3a: eine erste schematische Draufsicht zur Darstellung möglicher Verwendungen der erfindungsgemäßen Vorrichtung;
- Fig. 3b: ein der in Fig. 3a dargestellten Verwendung entsprechendes Ersatzschaltbild;
- Fig. 4a: eine zweite schematische Draufsicht zur Darstellung von Verwendungen der erfindungsgemäßen Vorrichtung;
- Fig. 4b: ein der in Fig. 4a dargestellten Verwendung entsprechendes Ersatzschaltbild;
- Fig. 4c: ein Diagramm mit gemessenen s-Parametern der in der Fig. 4a dargestellten Vorrichtung;
- Fig. 5a: eine dritte schematische Draufsicht zur Darstellung von Verwendungen der erfindungsgemäßen Vorrichtung;
- Fig. 5b: ein der in Fig. 5a dargestellten Verwendung entsprechendes Ersatzschaltbild; und
- Fig. 5c: ein Diagramm mit gemessenen s-Parametern der in der Fig. 5a dargestellten Vorrichtung.

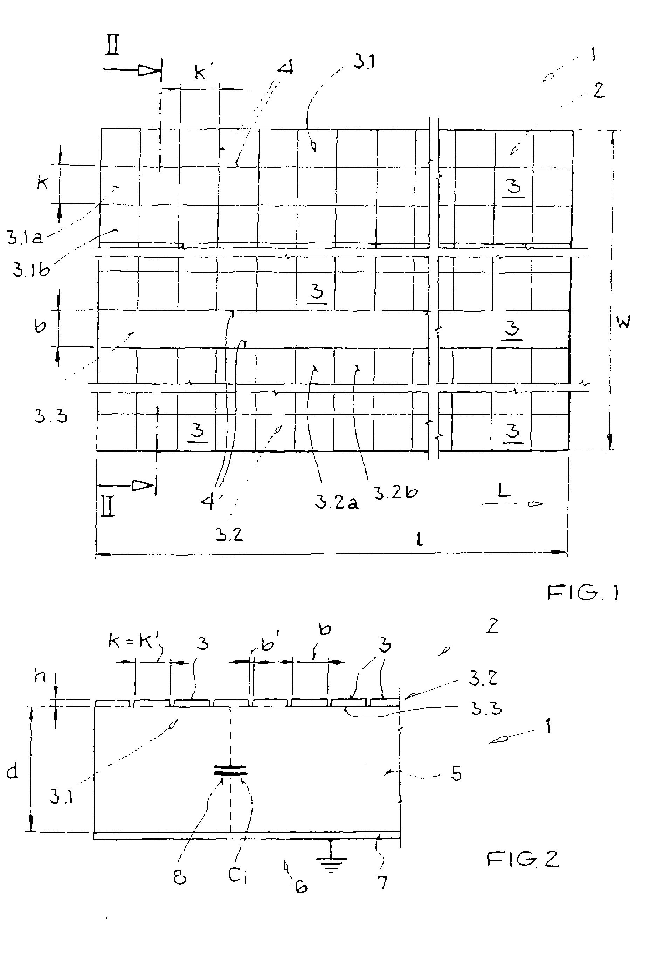

Die Fig. 1 zeigt in schematischer Draufsicht eine erfindungsgemäße Vorrichtung 1 zum Übertragen von elektromagnetischen Signalen. Die erfindungsgemäße Vorrichtung 1 ist als Halbzeug in Form einer Platte mit Länge I und Breite w ausgebildet. An ihrer in der Fig. 1 erkennbaren Oberseite 2 weist die Vorrichtung 1 eine elektrisch leitfähige Schicht 3 aus einem geeigneten Material auf, vorzugsweise aus Kupfer oder dergleichen. Erfindungsgemäß ist die Schicht 3 nicht uniform auf die Oberseite 2 der Vorrichtung 1 aufgebracht, sondern ist in ersten und zweiten Bereichen 3.1 bzw. 3.2 in Form einer Anordnung jeweils voneinander räumlich getrennter und gegeneinander elektrisch isolierter Felder 3.1 a, 3.1 b, ...; 3.2a, 3.2b, ... ausgebildet. Die Felder weisen nach dem Ausführungsbeispiel der Fig. 1 jeweils eine quadratische Form auf, d. h. für die Kantenlängen k, k' der einzelnen Felder 3.1 a, 3.1 b, ...; 3.2a, 3.2b, ... gilt jeweils k = k'. Darüber hinaus sind die einzelnen Felder in Form einer regelmäßigen Gitterstruktur angeordnet. Die räumliche Trennung und elektrische Isolierung der einzelnen Felder gegeneinander erfolgt über eine gitternetzartige Trennstruktur 4, welche zugleich die bereits erwähnte regelmäßige Anordnung der Felder bedingt. Die Trennstruktur 4 ist dabei vorzugweise durch Ätzen in einem Standardprozeß erzeugbar.

Nach dem Ausführungsbeispiel der Fig. 1 sind die vorstehend beschriebenen Bereiche 3.1, 3.2 durch einen sich in Längsrichtung L der Vorrichtung 1 erstreckenden durchgängigen Streifen 3.3 aus dem Material der leitfähigen Schicht 3 voneinander getrennt, wobei der Streifen 3.3 seitlich durch ebenfalls in Längsrichtung L der Vorrichtung 1 verlaufende Trennlinien 4' (linienförmige Trennstruktur) gegenüber den Bereichen 3.1, 3.2 bzw. den darin enthaltenen Feldern 3.1a, 3.1b, ...; 3.2a, 3.2b, ... elektrisch isoliert ist. Gemäß dem gezeigten Ausführungsbeispiel besitzt der durchgängige Streifen 3.3 eine Breite b, die den Kantenlängen k, k' der Felder entspricht, d. h. b = k = k'. Der durchgängige Streifen 3.3 ist nachfolgend auch als "Leitungsstreifen" bezeichnet.

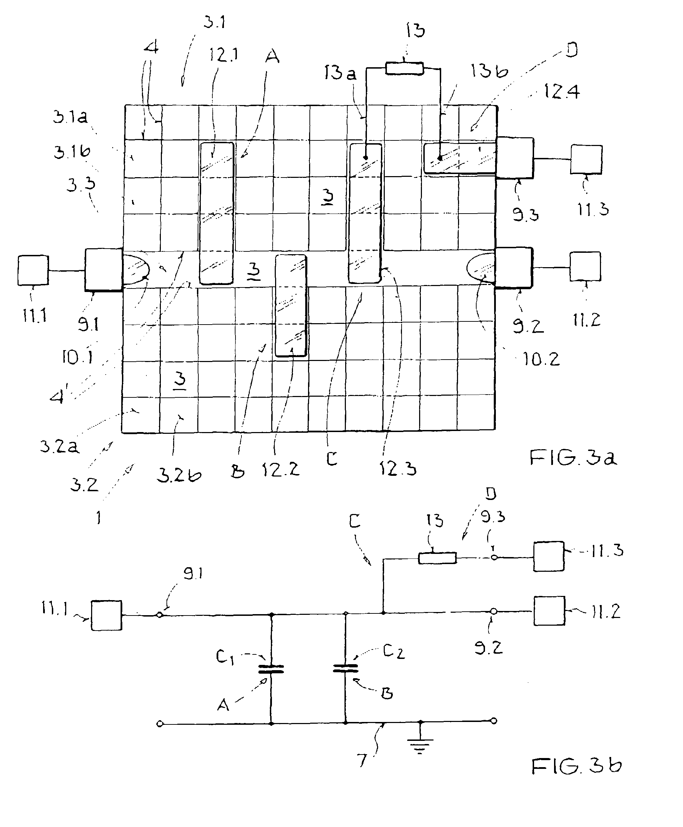

Die Fig. 2 zeigt einen Schnitt durch die erfindungsgemäße Vorrichtung 1 aus Fig. 1, etwa entlang einer Linie II-II (Fig. 1). Die Vorrichtung 1 weist demnach zunächst eine Trägerplatte 5 (Substrat) aus einem geeigneten elektrisch isolierenden Material auf, wobei es sich um ein typischerweise zur Herstellung von Leiterplatten verwendetes Epoxid-Material mit geeigneten dielelektrischen Eigenschaften, wie FR4 oder dgl., handeln kann. Die Trägerplatte 5 besitzt eine Dicke d, die bei Verwendung von FR4 erfindungsgemäß für 50 Ohm-Anwendungen vorzugsweise in einem Bereich von 0,5 mm bis 1,5 mm liegt. An ihrer Unterseite 6 ist die Vorrichtung 1 bzw. die Trägerplatte 5 mit einer elektrisch leitfähigen Schicht in Form einer Kupferschicht 7 kaschiert. Diese ist nach einer Ausgestaltung der vorliegenden Erfindung mit einem Bezugspotential, insbesondere mit Masse, verbunden. An der Oberseite 2 der Vorrichtung 1 bzw. der Trägerplatte 5 sind weiterhin die bereits vorstehend anhand der Fig. 1 beschriebenen Feld- und Streifenstrukturen mit den entsprechenden Trennstrukturen 4, 4' erkennbar.

Erfindungsgemäß ist der durchgängige Leiterstreifen 3.3 als 50 Ohm-Leitung ausgebildet. Aufgrund des gewählten Verhältnisses von Streifenbreite b und Feld-Kantenlängen k, k' stellen darüber hinaus auch die einzelnen Felder 3.1 a, 3.1 b, ...; 3.2a, 3.2b, ... jeweils für sich genommen Abschnitte einer 50 Ohm-Leitung dar, sodass zusätzlich zu dem durchgängigen Streifen 3.3 bei entsprechender Verbindung einzelner Felder über die Trennstrukturen 4, 4' hinweg in flexibler Weise weitere 50 Ohm-Leitungen herstellbar sind, worauf weiter unten noch detailliert eingegangen wird. Des Weiteren stellt jedes der Felder 3.1a, 3.1b, ...; 3.2a, 3.2b, ... gegenüber der Kupferschicht 7 (Masse) einen Kondensator 8 mit Kapazität Cᵢ dar, was in der Fig. 2 gestrichelt eingezeichnet ist. Vorzugsweise beträgt die Kapazität Cᵢ jedes einzelnen dieser Kondensatoren 8 etwa 0,3 pF. Zu diesem Zweck beträgt der gemeinsame Wert für b, k, k' im Falle d = 1,5 mm (FR4) vorzugsweise 2,54 mm und im Falle d = 0,5 mm (FR4) vorzugsweise 0,83 mm. Die Höhe h der leitfähigen Schicht 3 liegt erfindungsgemäß beispielsweise im Bereich von einigen Mikrometern, z.B. h = 17 µm oder h = 35 µm. Während der Wert für h praktisch keine Auswirkung auf die Kapazität Cᵢ hat, bestimmt er über die Querschnittsfläche den Widerstand der Leiterstrukturen (Felder, Leiterstreifen). Die Trennstrukturen besitzen eine Breite b', die einem Zehntel der Breite b, k, k' der Leiterstrukturen 4, 4' entspricht.

Unter Bezugnahme auf die nachfolgenden Figuren 3a bis 5c werden nun bevorzugte Verwendungsmöglichkeiten der vorstehend erläuterten erfindungsgemäßen Vorrichtung 1 nach Art eines Halbzeugs beschrieben:

Die Fig. 3a zeigt mögliche Verwendungen der vorstehend anhand der Fig. 1, 2 beschriebenen erfindungsgemäßen Vorrichtung 1 - zunächst ohne konkreten schaltungstechnischen Anwendungsfall. Dazu ist die Vorrichtung 1 im Bereich einander gegenüberliegender Enden des durchgängigen Leiterstreifens 3.3 jeweils mit einer Anschlusseinrichtung 9.1, 9.2, beispielsweise zum Anschließen eines geeigneten Steckverbinders (nicht gezeigt) versehen. Die Anschlusseinrichtungen 9.1, 9.2 sind jeweils mittels einer Lötverbindung 10.1, 10.2 auf dem durchgängigen Streifen 3.3 befestigt. Mit den Anschlusseinrichtungen 9.1, 9.2 ist jeweils eine elektrische Funktionseinheit 11.1 bzw. 11.2 verbunden, wobei zwischen den Funktionseinheiten 11.1, 11.2 eine Übertragung elektromagnetischer Signale, vorzugsweise hochfrequenter elektromagnetischer Signale im Gigahertz-Bereich, stattfindet. Beispielsweise kann es sich bei der ersten Funktionseinheit 11.1 um einen HF-Signalgenerator und bei der zweiten Funktionseinheit 11.2 um eine Messspinne / Messfassung (mit ggf. daran angeschlossenem Meßgerät) handeln. Die Signalübertragung zwischen den Funktionseinheiten 11.1, 11.2 erfolgt somit erfindungsgemäß grundsätzlich über den als 50 Ohm-Leitung ausgebildeten durchgängigen Streifen 3.3. Allerdings weisen Hochfrequenz (HF)-Baugruppen, wie die angesprochenen Funktionseinheiten 11.1, 11.2, regelmäßig an ihren jeweiligen Ein- und Ausgängen komplexwertige Widerstände (Impedanzen) auf, die in der Regel nicht auf die Impedanz einer anderen Baugruppe / Funktionseinheit abgestimmt sind, mit der die erste Funktionseinheit / Baugruppe signaltechnisch in Wechselwirkung tritt, wie dies bei den oben erwähnten Funktionseinheiten 11.1, 11.2 der Fall ist. Auch weitere im Signalübertragungsweg zwischen den Funktionseinheiten enthaltene Baugruppen, wie die Messkontakte einer Messfassung oder die Anschlusseinrichtungen 9.1, 9.2 können zu einer derartigen Fehlabstimmung der Impedanz beitragen. Es ist daher erforderlich, die Impedanzen am Eingang und Ausgang von HF-Baugruppen zu transformieren, um sie aneinander anzupassen.

Dies lässt sich bei Verwendung der erfindungsgemäßen Vorrichtung 1 dadurch erreichen, dass der Leitung zwischen den Funktionseinheiten 11.1, 11.2, d. h. im Falle der vorliegenden Erfindung dem durchgängigen Leiterstreifen 3.3 in geeigneter Weise eine Kapazität (gegebenenfalls bestehend aus mehreren Einzelkapazitäten) parallel geschaltet wird. Zu diesem Zweck sind im Ausführungsbeispiel der Fig. 3a in Bereichen A, B jeweils ausgehend von dem durchgängigen Leiterstreifen 3.3 eine Mehrzahl von Feldern des Bereichs 3.1 bzw. 3.2 an der Oberseite 2 der Vorrichtung 1 über die Trennstrukturen 4, 4' hinweg miteinander und mit dem durchgängigen Leiterstreifen 3.3 elektrisch leitend verbunden, beispielsweise durch Aufbringen von Lötzinn in den entsprechenden Bereichen A, B, was allgemein in der vorliegenden und den folgenden Figuren mittels Schraffierungen dargestellt ist. Auf diese Weise sind in den Bereichen A, B durch die resultierenden Zinnbrücken 12.1 bzw. 12.2 jeweils Stich- oder Blindleitungen gebildet, die je nach Lage und Anzahl der verbundenen Felder einen zu dem durchgängigen Leiterstreifen 3.3, d. h. der Leitung zwischen den Funktionseinheiten 11.1, 11.2 parallelen Kondensator mit einer entsprechenden Kapazität Cᵢ darstellen. Dabei haben die Lötzinnbrücken 12.1, 12.2 praktisch kaum Einfluß auf den Impedanzwert der Leitung, der im hier vordringlich interessanten HF-Bereich durch den kapazitiven Anteil dominiert wird.

Alternativ zur vorstehend beschriebenen Verbindungsmethode unter Verwendung von Lötzinn ist auch die Verwendung von auf der Oberseite 2 der Vorrichtung 1 verschiebbaren und verstellbaren Kurzschlusselementen (nicht gezeigt) möglich. Bei Letzteren kann es sich vorzugsweise um quaderförmige Elemente aus Polystyrol-Schaumstoff handeln, die im HF-Spektralbereich quasi "unsichtbar" sind und die an einer Quaderfläche mit einer elektrisch leitfähigen Schicht versehen werden, z.B. durch Aufkleben eines Stücks Kupferfolie mit einer bestimmten Geometrie. Durch das Verändern der Position und Größe (Abmessung der Kupferfolie) der so erzeugten Kapazität(en) lässt sich somit erfindungsgemäß auf einem Smith-Diagramm nahezu jeder Punkt erreichen, sodass eine weitreichende Anpassung von Impedanzen möglich ist. Anschließend können dann die so ermittelten Anpassungs-Kapazitäten durch Zinnbrücken (s.o.) dauerhaft realisiert werden.

Darüber hinaus zeigt die Fig. 3a in Bereichen C, D noch weitere Zinnbrücken 12.3 bzw. 12.4, die jeweils analog zu den vorstehend detailliert beschriebenen Zinnbrücken 12.1, 12.2 ausgebildet sind. Dabei erstreckt sich die Zinnbrücke 12.3 von dem durchgängigen Streifen 3.3 weg und zugleich senkrecht zu dessen Verlaufsrichtung, wohingegen die Zinnbrücke 12.4 im Bereich D parallel zu dem durchgängigen Streifen 3.3 verläuft und diesen nicht kontaktiert. Des Weiteren sind die Zinnbrücken 12.3, 12.4 miteinander über ein diskretes elektronisches Bauelement, hier: einen Widerstand 13, verbunden, dessen Anschlüsse 13a, 13b mit in die Zinnbrücken 12.3, 12.4 integriert sind, sodass die darunter liegenden Felder gleichermaßen als Lötstützpunkte für den Widerstand 13 dienen. Mit der Lötbrücke 12.4 ist weiterhin im Randbereich der Vorrichtung 1 eine weitere Anschlusseinrichtung 9.3 und über diese eine weitere Funktionseinheit 11.3 verbunden. Auf diese Weise wurden erfindungsgemäß in den erwähnten Bereichen C, D durch geeignetes Verbinden von Feldern weitere, durch die Zinnbrücken 12.3, 12.4 definierte Teilabschnitte einer 50 Ohm-Leitung zusätzlich zu dem Leiterstreifen 3.3 erzeugt. Bei entsprechender Weiterführung dieses erfindungsgemäßen Grundgedankens lassen sich somit unter Verwendung der erfindungsgemäßen Vorrichtung 1 und geeigneter diskreter Bauelemente beliebige Schaltungsstrukturen realisieren, insbesondere für die HF-Schaltungs- oder Prototypentwicklung, zum Beispiel Bandfilter, Hochpässe, Tiefpässe, Schwingkreise, Saugkreise, Verstärker oder dergleichen, welche dem Fachmann an sich bekannt sind.

Die Fig. 3b zeigt ein zu der vorstehend anhand der Fig. 3a erläuterten Verwendung der erfindungsgemäßen Vorrichtung vereinfachtes äquivalentes Schaltbild. Dabei sind bezüglich der vorstehend gegebenen Erläuterung der erfindungsgemäßen Vorrichtung gleiche oder identische Elemente mit denselben Bezugszeichen versehen. Insbesondere ist aus der Darstellung der Fig. 3b ersichtlich, wie in den Bereichen A, B zu der "eigentlichen" Leitung (durchgängiger Leiterstreifen 3.3) parallele Kapazitäten C₁, C₂ geschaltet sind, über die in flexibler Weise eine Impedanztransformation zwischen den Funktionseinheiten 11.1, 11.2 erreichbar ist. Das dargestellte Schaltbild ist insoweit vereinfacht, als nur die mittels der Zinnbrücken 12.1, 12.2 (Fig. 3a) realisierten Kapazitäten nicht jedoch weitere, miterzeugte Bauteile, wie Induktivitäten oder Widerstände, explizit gezeigt sind.

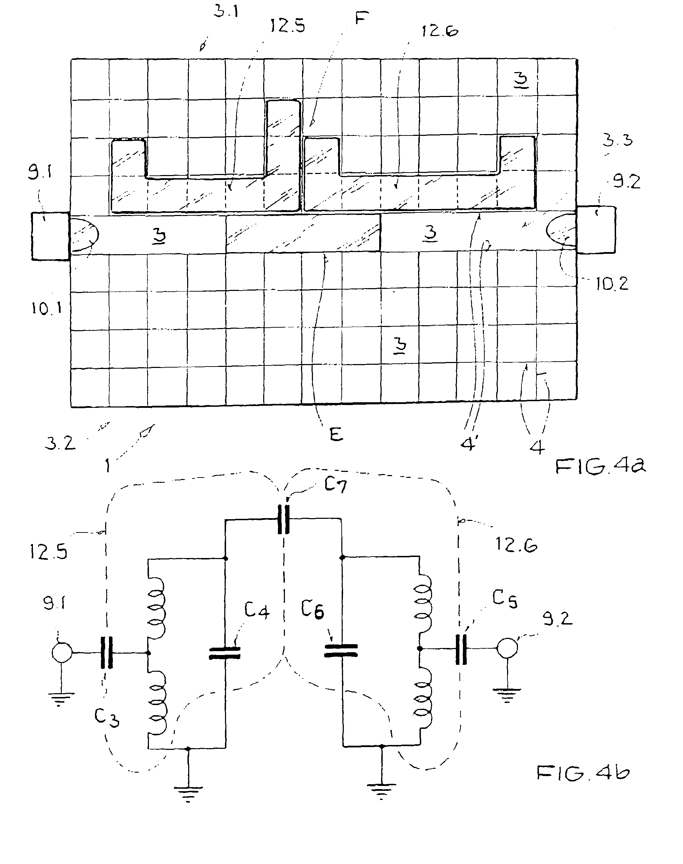

Die Fig. 4a zeigt ein weiteres Anwendungsbeispiel der erfindungsgemäßen Vorrichtung 1 zur Realisierung eines zweikreisigen Bandfilters, beispielsweise bei einer Signalfrequenz von 2,4 GHz. Gemäß der vorliegenden Darstellung sind mit dem Streifen 3.3 wiederum entsprechend der Fig. 3a Anschlusseinrichtungen 9.1, 9.2 verbunden, die wiederum mit geeigneten Funktionseinheiten 11.1, 11.2 in Wirkverbindung stehen. Allerdings ist beim Anwendungsbeispiel der Fig. 4a der an sich durchgängige Leiterstreifen 3.3 in einem mittleren Teilstück E durch mechanisches Entfernen (Kratzen) der leitfähigen Schicht 3 elektrisch unterbrochen. Des Weiteren sind im Bereich 3.1 - oberhalb des Streifens 3.3 - zwei im wesentlichen U-förmige (an den Enden abgekröpfte) Strukturen 12.5, 12.6 in Form von Zinnbrücken gebildet, die jeweils eine bestimmte Anzahl von Feldern über die Trennstruktur 4 hinweg miteinander verbinden.

Dabei ist der jeweils mittlere, d.h. nicht-freie Schenkel der U-förmigen Strukturen 12.5, 12.6 parallel zu dem Leiterstreifen 3.3 ausgerichtet. Eine elektrisch leitende Verbindung sowohl zwischen den Zinnbrücken 12.5, 12.6 und dem Streifen 3.3 als auch zwischen den Zinnbrücken 12.5, 12.6 untereinander besteht nicht (galvanische Trennung, rein kapazitiv-induktive Kopplung).

Die Fig. 4b zeigt das entsprechende äquivalente Schaltbild, wobei wiederum identische oder ähnliche Elemente mit denselben Bezugszeichen versehen sind. Wie aus der Fig. 4b erkennbar, sind die Kapazitäten C₃, C₄ durch die Zinnbrücke 12.5 bzw. die hierdurch verbundenen Felder der Vorrichtung 1 und die Masse 7 (Kondensator C₄) gebildet. Entsprechend bedingt die Zinnbrücke 12.6 die Existenz der Kapazitäten C₅, C₆. Die zur kapazitiven Kopplung der beiden derart gebildeten Kreise benötigte Kapazität C₇ entsteht aufgrund der eng benachbarten Anordnung der Zinnbrücken 12.5, 12.6 im Bereich F (Fig. 4a). Vorliegend stellen die Zinnbrücken 12.5, 12.6 demnach sog. Resonatoren dar, die neben den bereits beschriebenen kapazitiven Eigenschaften auch induktive und natürlich resistive Eigenschaften besitzen, wie aus der Fig. 4b ebenfalls zu entnehmen ist.

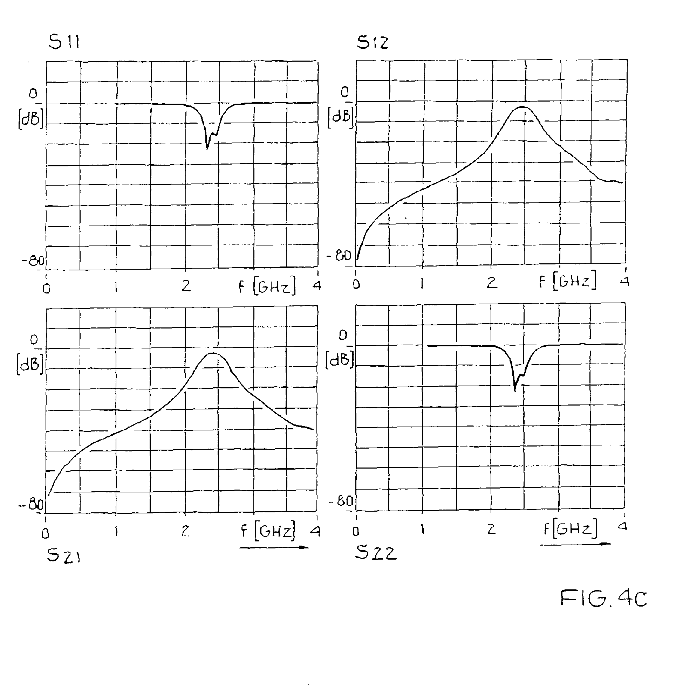

Die Fig. 4c zeigt die für die in den Fig. 4a, b dargestellte Verwendung der erfindungsgemäßen Vorrichtung zur Herstellung eines Zweikreis-Bandfilters bestimmten s-Parameter, welche zu den in der HF-Technik gebräuchlichen Vierpolparametern zählen und das Verhalten eines elektronischen Bauteils beschreiben. Ein Zweitor wird durch vier s-Parameter beschrieben - S11, S12, S21, S22. Dabei ist S11 der Reflexionsfaktor am Eingang bei Abschluss (mit dem entsprechenden Wellenwiderstand) am Ausgang, S12 ist die Rückwärtsverstärkung bei Abschluss am Eingang, S21 ist die Vorwärtsverstärkung bei Abschluss am Ausgang und stellt somit auch die sog. Einfügedämpfung dar, S22 ist der Reflexionsfaktor am Ausgang bei Abschluss am Eingang. In heutigen Hochfrequenzlabors werden die s-Parameter mit Hilfe eines Netzwerkanalysators (engl. (Vector) Network Analyser / VNA) als Funktion der Frequenz gemessen. Die Parameter sind dimensionslose komplexe Zahlen und werden in der Praxis als Betrag in dB und Phase in Grad angegeben. Eine Darstellung im Smith-Diagramm als Ortskurve der Frequenz ist üblich. Bei Verwendung der im Rahmen der vorliegenden Erfindung geschaffenen Vorrichtung lassen sich - wie oben beschrieben - durch entsprechendes Anpassen der s-Parameter quasi beliebige Punkte im Smith-Diagramm erreichen.

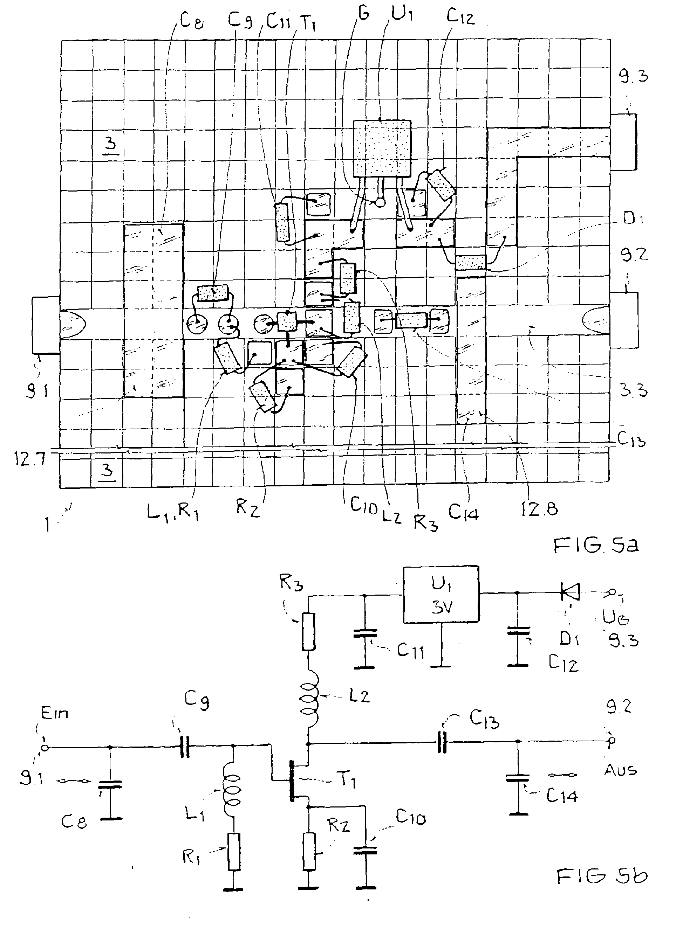

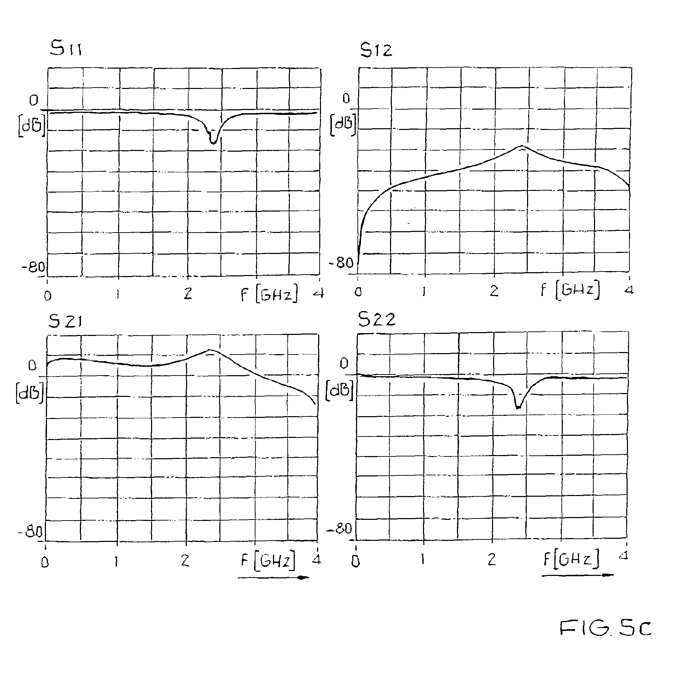

Die Fig. 5a zeigt ein weiteres Anwendungsbeispiel der erfindungsgemäßen Vorrichtung 1 zur Realisierung einer an sich bekannten Verstärkerschaltung, deren detailliertes Schaltbild in der Fig. 5b gezeigt ist, wobei einander entsprechende Elemente in beiden Figuren dieselben Bezugszeichen tragen, z.B. Kapazitäten C₈-C₁₄, Widerstände R₁-R₃, Spulen L₁-L₂, Spannungsregler U₁, Transistor T₁ und Diode D₁. Gemäß der vorliegenden Darstellung sind mit dem Streifen 3.3 wiederum entsprechend der Fig. 3a, 4a Anschlusseinrichtungen 9.1-9.3 für Eingang, Ausgang und Versorgungsspannung U_{B} verbunden, die wiederum mit geeigneten Funktionseinheiten (nicht gezeigt) in Wirkverbindung stehen. Wie aus den Fig. 5a,b erkennbar, ist speziell die Kapazität C₈ zur eingangsseitigen Impedanzanpassung durch Zinnbrücke 12.7 bzw. die hierdurch verbundenen Felder der Vorrichtung 1 und Masse 7 (Fig. 2) gebildet. Entsprechend bedingt Zinnbrücke 12.8 die Existenz der Kapazität C₁₄ zur ausgangsseitigen Impedanzanpassung. Gemäß der Doppelpfeile in Fig. 5b sind beide Kapazitäten C₈, C₁₄ in Größe (geometrischer Abmessung) und Position flexibel anpassbar. Die weiteren Bauelemente sind als diskrete Bauteile herkömmlicher Art ausgebildet und auf die erfindungsgemäße Vorrichtung 1 aufgelötet (schraffierte Bereiche). Bei G ist der Masseanschluss des Spannungsreglers U₁ durch Anbringen einer Bohrung bis auf die Masseschicht 7 (Fig. 2) verbunden, wie weiter oben bereits angesprochen. Entsprechend lassen sich auch die weiteren Masseverbindungen gemäß der Fig. 5b realisieren.

Fig. 5c zeigt die s-Parameter der Schaltungsanordnung aus den Figuren 5a und 5b, wobei wiederum alle vier s-Parameter s₁₁, s₁₂, s₂₁, s₂₂ dargestellt sind.

Die vorliegende Erfindung eröffnet somit vielfältige schaltungstechnische Möglichkeiten, die mit anderen Leiterplatten, beispielsweise Experimentier-Platinen mit Loch- oder Streifenraster nicht erreichbar sind. Bespielsweise lässt sich an beliebigen Stellen der erfindungsgemäßen Vorrichtung durch Durchbohren des Subtrats 5 (Fig. 2) und Einlöten eines elektrisch leitenden Verbindungselements (z.B. eines Drahtabschnitts; nicht gezeigt) in flexibler Weise eine extrem kurze Verbindung mit Masse herstellen.
Weiterhin lässt sich beispielsweise durch Aufbringen einer spiralförmigen Lötzinnstruktur auch eine Spule in einfacher Weise realisieren.

### Bezugszeichenliste

- 1: Vorrichtung
- 2: Oberseite
- 3: leitfähige Schicht
- 3.1: Bereich
- 3.1a, 3.1b, ...: Feld
- 3.2: Bereich
- 3.2a, 3.2b, ...: Feld
- 3.3: Leiterstreifen
- 4, 4': Trennstruktur
- 5: Trägerplatte
- 6: Unterseite
- 7: Kupferschicht, Masse
- 8: Kondensator
- 9.1, 9.2, 9.3: Anschlusseinrichtung
- 10.1, 10.2: Lötverbindung
- 11.1, 11.2, 11.3: Funktionseinheit
- 12.1-12.8: Zinnbrücke
- 13: Widerstand
- 13a, 13b: Anschluss
- A: Bereich
- B: Bereich
- b: Breite
- b': Breite
- C: Bereich
- Cᵢ: Kapazität
- C₁-C₁₄: Kapazität
- D: Bereich
- D₁: Diode
- d: Dicke
- E: Bereich
- F: Bereich
- G: Bereich
- h: Höhe
- k: Kantenlänge
- k': Kantenlänge
- L: Längsrichtung
- L₁, L₂: Spule
- I: Länge
- R₁-R₃: Widerstand
- T₁: Transistor
- U_{B}: Versorgungsspannung
- U₁: Spannungsregler
- w: Breite

## Patentansprüche

1. Vorrichtung (1) zum Übertragen von elektromagnetischen Signalen zwischen wenigstens einer ersten (11.1) und wenigstens einer zweiten Funktionseinheit (11.2), aufweisend:
- ein elektrisch isolierendes Substrat (5) mit einer Oberseite (2) und mit einer Unterseite (6),
- eine erste elektrisch leitfähige Schicht (7) aus einem ersten Beschichtungsmaterial auf der Unterseite (6) des Substrats (5), die mit einem Bezugspotential verbindbar ist, und
- eine zweite elektrisch leitfähige Schicht (3) aus einem zweiten Beschichtungsmaterial auf der Oberseite (2) des Substrats (5), wobei die zweite leitfähige Schicht (3) in wenigstens einem Bereich (3.1, 3.2) in Form jeweils voneinander räumlich getrennter und gegeneinander elektrisch isolierter Felder (3.1 a, 3.1 b, ...; 3.2a, 3.2b, ...) aus dem zweiten Beschichtungsmaterial ausgebildet ist,
**dadurch gekennzeichnet, dass** die Felder (3.1 a, 3.1 b, ...; 3.2a, 3.2b, ...) bereichsweise gegenüber der ersten elektrisch leitfähigen Schicht (7) jeweils eine gleiche, vorbestimmte Kapazität (Cᵢ) aufweisen und dass durch Vorsehen elektrisch leitender Verbindungen (12.1-12.6) zwischen einer Anzahl von diesen Feldern (3.1 a, 3.1 b, ...; 3.2a, 3.2b, ...) an einer Oberseite der zweiten leitfähigen Schicht (3) ein Transformationsverhalten der Vorrichtung (1) zur Impedanzanpassung gezielt einstellbar ist.

2. Vorrichtung (1) nach Anspruch 1, **dadurch gekennzeichnet, dass** die Felder (3.1 a, 3.1 b, ...; 3.2a, 3.2b, ...) bereichsweise gleiche Abmessungen aufweisen.

3. Vorrichtung (1) nach Anspruch 1 oder 2, **dadurch gekennzeichnet, dass** die Felder (3.1 a, 3.1 b, ...; 3.2a, 3.2b, ...) bereichsweise gitterförmig angeordnet sind.

4. Vorrichtung (1) nach Anspruch 3, **dadurch gekennzeichnet, dass** das Gitter eine regelmäßige Gitterstruktur aufweist.

5. Vorrichtung (1) nach Anspruch 3 oder 4, **dadurch gekennzeichnet, dass** das Gitter ein quadratisches Gitter ist.

6. Vorrichtung (1) nach einem der Ansprüche 1 bis 5, **gekennzeichnet durch** wenigstens einen durchgängigen und gegenüber dem Bereich (3.1, 3.2) der zweiten Schicht (3) elektrisch isolierten Streifen (3.3) aus einem elektrisch leitfähigen Beschichtungsmaterial, vorzugsweise dem zweiten Beschichtungsmaterial.

7. Vorrichtung (1) nach Anspruch 6, **gekennzeichnet durch** mindestens zwei Bereiche (3.1, 3.2) mit Feldern (3.1 a, 3.1 b, ...; 3.2a, 3.2b, ...) des zweiten Beschichtungsmaterials, die **durch** den durchgängigen Streifen (3.3) voneinander getrennt sind.

8. Vorrichtung (1) nach einem der Ansprüche 1 bis 7, **dadurch gekennzeichnet, dass** das Substrat (5) in Form einer Substratplatte ausgebildet ist.

9. Vorrichtung (1) nach einem der Ansprüche 1 bis 8, **dadurch gekennzeichnet, dass** mit dem zweiten Beschichtungsmaterial (3) weitere elektrische Funktionseinheiten (13), insbesondere diskrete elektrische Bauelemente, elektrisch leitend verbindbar sind, insbesondere durch Lötverbindungen (10.1, 10.2).

10. Vorrichtung (1) nach einem der Ansprüche 6 bis 9, **dadurch gekennzeichnet, dass** der durchgängige Streifen (3.3) als Leitung mit einem vorbestimmten Ohmschen Widerstand, vorzugsweise als 50 Ohm-Leitung, ausgebildet ist.

11. Vorrichtung (1) nach einem der Ansprüche 1 bis 10, **dadurch gekennzeichnet, dass** zumindest eine bereichsweise zusammengehörige Anzahl von Feldern (3.1 a, 3.1 b, ...; 3.2a, 3.2b, ...) der zweiten elektrisch leitfähigen Schicht (3) denselben Ohmschen Widerstand wie der durchgängige Streifen (3.3) aufweist.

12. Vorrichtung (1) nach einem der Ansprüche 1 bis 11, **dadurch gekennzeichnet, dass** zumindest das zweite Beschichtungsmaterial zum Schaffen elektrischer Trennstrukturen (E) bereichsweise von dem Substrat (5) entfernbar ist, insbesondere mit mechanischen Mitteln.

13. Verwendung der Vorrichtung (1) nach einem der Ansprüche 1 bis 12 zum Herstellen eines Impedanz-Transformationsnetzwerks.

14. Verfahren zum Herstellen eines Impedanz-Transformationsnetzwerks unter Verwendung der Vorrichtung (1) nach einem der Ansprüche 1 bis 12, **dadurch gekennzeichnet; dass**
- eine erste Funktionseinheit (11.1) mit einer ersten Anschlussimpedanz elektrisch leitend in einem ersten Bereich (3.3) mit der zweiten elektrisch leitfähigen Schicht (3) verbunden wird,
- eine zweite Funktionseinheit (11.2) mit einer zweiten Anschlussimpedanz elektrisch leitend in einem zweiten Bereich (3.3) mit der zweiten leitfähigen Schicht (3) verbunden wird,
- falls der erste und zweite Bereich nicht durch eine leitfähige Verbindung aus dem zweiten Beschichtungsmaterial miteinander verbunden sind, an der Oberseite der zweiten elektrisch leitfähigen Schicht (3) eine elektrisch leitfähige Verbindung zwischen dem ersten und dem zweiten Bereich hergestellt wird, und
- ausgehend von der leitfähigen Verbindung eine Anzahl von an ihrem jeweiligen Ende offenen Stichleitungen durch Verbinden jeweils einer Anzahl von Feldern mit einem elektrisch leitfähigen Material sowohl untereinander als auch mit der leitfähigen Verbindung an der Oberseite der zweiten elektrisch leitfähigen Schicht erzeugt wird, wobei eine jeweilige Position und Anzahl von Feldern derart gewählt wird, dass eine Differenz zwischen den ersten und zweiten Anschlussimpedanzen ausgeglichen wird.

15. Verfahren nach Anspruch 14, **dadurch gekennzeichnet, dass** die Funktionseinheiten (11.1, 11.2) jeweils mit dem durchgängigen Streifen (3.3) gemäß Anspruch 5 verbunden werden.

16. Verwendung der Vorrichtung (1) nach einem der Ansprüche 1 bis 12 zur Entwicklung von Schaltungsanordnungen.

17. Verfahren zum Entwickeln von Schaltungsanordnungen unter Verwendung der Vorrichtung (1) nach einem der Ansprüche 1 bis 12, **dadurch gekennzeichnet, dass** eine Mehrzahl von Funktionseinheiten (11.1, 11.2) jeweils in Bereichen (C, D) der zweiten elektrisch leitfähigen Schicht (3) elektrisch leitend mit dieser verbunden werden und wobei wenigstens eine Anzahl von Feldern (3.1 a, 3.1b, ...) mit einem elektrisch leitfähigen Material an der Oberseite der zweiten elektrisch leitfähigen Schicht (3) miteinander verbunden werden, sodass die verbundenen Felder mit den Funktionseinheiten in signaltechnischer Wirkverbindung stehen.

18. Verfahren nach Anspruch 17, **dadurch gekennzeichnet, dass** diskrete elektronische Bauelemente (13), wie Widerstände, Kondensatoren, LEDs, Schalter usw., mit Feldern (3.1a, 3.1b, ...) der zweiten elektrisch leitfähigen Schicht (3) elektrisch leitend verbunden werden, sodass die verbundenen Felder mit den Funktionseinheiten in signaltechnischer Wirkverbindung stehen.

19. Verfahren nach Anspruch 17 oder 18, **dadurch gekennzeichnet, dass** das Verbinden einzelner Felder (3.1 a, 3.1b, ...) mittels eines geeigneten diskreten Bauelements (13) erfolgt.
